# DEMANDE DE BREVET EUROPEEN

(11) **EP 2 328 182 A1**
(43) Date de publication de la demande: **01.06.2011**
(21) Numéro de dépôt: 10192917.2
(22) Date de dépôt: 29.11.2010
(51) Int. Cl.: H01L 31/028, H01L 31/0392, H01L 31/18, C04B 35/65, H01L 27/142

(54) **Module photovoltaïque comportant des cellules photovoltaïques intégrées**

(30) Priorité: 27.11.2009 FR 0958441
(71) Demandeur: S'Tile, 86180 Buxerolles (FR)
(72) Inventeur: Straboni, Alain, 86180, BUXEROLLES (FR); Turlot, Emmanuel, 38700, CORENC (FR)
(74) Mandataire: de Beaumont, Michel

(57) **Abrégé**

L'invention concerne un module photovoltaïque et son procédé de réalisation. Le module comprend un support en silicium fritté comportant plusieurs cellules photovoltaïques intégrées et connectées en série.

## Description

### Domaine de l'invention

La présente invention concerne de façon générale le domaine photovoltaïque et plus particulièrement les modules photovoltaïques, dits aussi panneaux solaires, comportant des cellules photovoltaïques.

### Exposé de l'art antérieur

Dans l'état de la technique, on connaît des modules photovoltaïques réalisés à partir de cellules photovoltaïques individuelles en silicium mono- ou multicristallin connectées en série par soudure et assemblées sur un cadre rigide.

De tels modules présentent l'inconvénient de nécessiter un assemblage des cellules une à une et sont peu efficaces en terme de coût.

### Résumé

Un objet de la présente invention est de prévoir des modules photovoltaïques moins chers et/ou plus performants que ceux de l'art antérieur.

Un autre objet de la présente invention est de pallier tout ou partie des inconvénients de l'art antérieur, et/ou de proposer des alternatives à l'art antérieur.

Ainsi, un mode de réalisation de la présente invention prévoit un module photovoltaïque comprenant un support en silicium fritté comportant plusieurs cellules photovoltaïques intégrées.

Selon un mode de réalisation de la présente invention, les cellules photovoltaïques sont isolées les unes des autres par des parties oxydées du support en silicium fritté.

Selon un mode de réalisation de la présente invention, les parties oxydées s'étendent d'une face à l'autre du support.

Selon un mode de réalisation de la présente invention, les cellules photovoltaïques sont connectées en série.

Selon un mode de réalisation de la présente invention, chacune des cellules photovoltaïques comprend une première zone fortement dopée d'un premier type dans et/ou sur le support et une deuxième zone disposée au moins en partie sur la première zone, d'un dopage de même type que la première zone et moins dopée que la première zone, la première zone définissant une première borne de la cellule photovoltaïque.

Selon un mode de réalisation de la présente invention, chacune des cellules photovoltaïques comprend une troisième zone dopée d'un deuxième type différent du premier type et disposée sur la deuxième zone, la troisième zone définissant une deuxième borne de la cellule.

Selon un mode de réalisation de la présente invention, chacune des cellules photovoltaïques comprend une quatrième zone fortement dopée d'un deuxième type différent du premier type et disposée sous la deuxième zone, la quatrième zone définissant une deuxième borne de la cellule.

Selon un mode de réalisation de la présente invention, le module comprend des vias permettant la connexion des cellules par la face arrière du support destinée à ne pas être exposée au soleil.

Selon un mode de réalisation de la présente invention, les cellules photovoltaïques ont la forme de bandes s'étendant d'un bord à l'autre du module.

La présente invention concerne aussi un procédé de fabrication d'un module photovoltaïque comprenant un support comportant plusieurs cellules photovoltaïques intégrées, le support étant réalisé au cours d'une étape consistant à fritter des poudres de silicium.

Selon un mode de réalisation de la présente invention, le procédé comporte une étape consistant à introduire localement un agent oxydant dans le support de façon à le rendre localement isolant afin de réaliser, dans le support, des zones isolées électriquement les unes des autres.

Selon un mode de réalisation de la présente invention, les cellules photovoltaïques sont réalisées sur lesdites zones isolées électriquement les unes des autres.

Selon un mode de réalisation de la présente invention, la réalisation des cellules photovoltaïques comprend les étapes suivantes :
a) réaliser une première zone, fortement dopée d'un premier type, dans ou sur le support, la première zone définissant une première borne de la cellule photovoltaïque ;
b) réaliser sur la première zone une deuxième zone d'un dopage de même type que la première zone et moins dopée que la première zone ; et
c) réaliser sur la deuxième zone une troisième zone dopée d'un deuxième type différent du premier type, la troisième zone définissant une deuxième borne de la cellule photovoltaïque.

Selon un mode de réalisation de la présente invention, la réalisation des cellules photovoltaïques comprend les étapes suivante :
a) réaliser une première zone fortement dopée d'un premier type dans et sur le support, la première zone définissant une première borne de la cellule photovoltaïque ;
b) réaliser, dans et sur le support, une deuxième zone fortement dopée d'un deuxième type différent du premier type, adjacente et sans contact avec la première zone, la deuxième zone définissant une deuxième borne de la cellule photovoltaïque ; et
c) réaliser sur les première et deuxième zones une troisième zone d'un dopage de même type que la première zone et moins dopée que la première zone.

Selon un mode de réalisation de la présente invention, le procédé comprend une étape consistant à connecter au moins deux cellules photovoltaïques en série.

### Brève description des dessins

Ces objets, caractéristiques et avantages, ainsi que d'autres seront exposés en détail dans la description suivante de modes de réalisation particuliers faite à titre non-limitatif en relation avec les figures jointes parmi lesquelles :
les figures 1A à 1H illustrent un premier exemple de réalisation d'un module photovoltaïque selon un mode de réalisation de la présente invention ;
les figures 2A à 2G illustrent un deuxième exemple de réalisation d'un module photovoltaïque selon un mode de réalisation de la présente invention ; et
les figures 3A à 3C illustrent un troisième exemple de réalisation d'un module photovoltaïque selon un mode de réalisation de la présente invention.

### Description détaillée

Par souci de clarté, de mêmes éléments peuvent avoir été désignés par de mêmes références aux différentes figures et, de plus, comme cela est habituel dans la représentation des circuits intégrés, les diverses figures ne sont pas tracées à l'échelle.

La présente invention est remarquable en ce que les modules photovoltaïques selon la présente invention comportent un support réalisé par frittage de poudres de silicium.

Une plaquette en silicium fritté se distingue d'une plaquette en silicium monocristallin, polycristallin ou multicristallin car elle est moins dense et présente une porosité non nulle. En effet, une plaquette classique en silicium monocristallin, polycristallin ou multicristallin résulte d'un bain fondu et présente une porosité nulle, alors qu'une plaquette en silicium fritté présente toujours une certaine porosité, sauf éventuellement dans des zones où elle aurait été fondue, par exemple lors d'un recuit ultérieur.

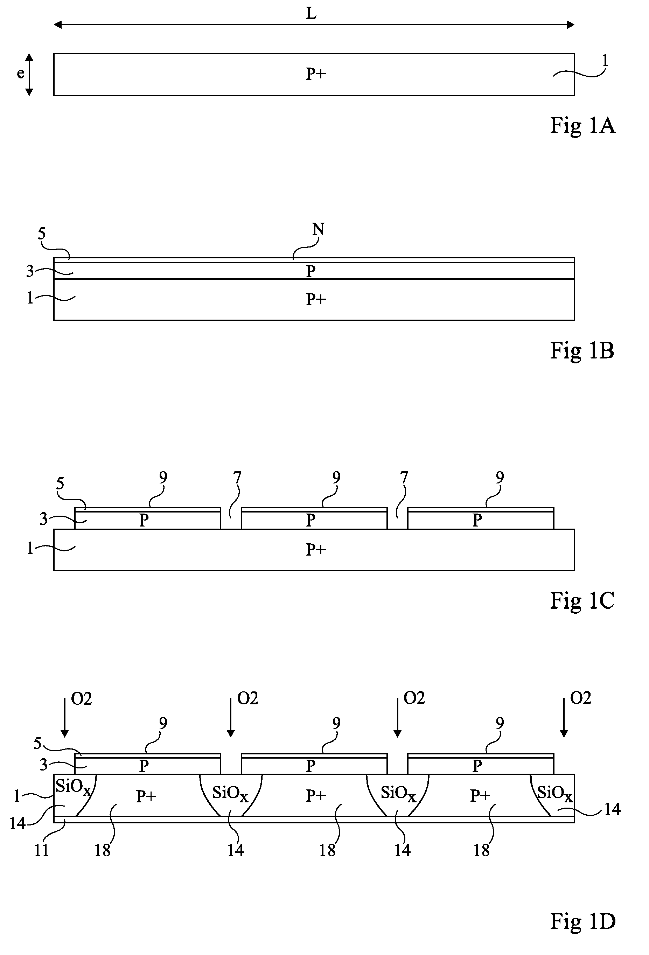

Un premier exemple de réalisation d'un module photovoltaïque va être décrit en relation avec les figures 1A à 1G.

La figure 1A représente un support 1 parallélépipédique en silicium fritté. Le support 1 a une épaisseur e typique de l'ordre de 400 µm à 1 mm. Bien entendu, le support 1 peut être plus épais, comme aller jusqu'à quelques millimètres. La longueur L et la largeur du support 1 peuvent être assez grandes, de l'ordre de plusieurs dizaines de centimètres, voire plus. Par exemple, le support 1 a des faces rectangulaires de dimension 400 par 700 millimètres.

Le support 1 a été obtenu par frittage de poudres de silicium. Les poudres utilisées sont par exemple de taille micrométrique et le support 1 présente des grains de silicium de taille micrométrique. Les conditions de frittage des poudres (température, pression, durée, etc) sont contrôlées et le support 1 présente une porosité déterminée. Par exemple, la porosité va de quelques pourcents à 30 ou 50 pourcents. La porosité du support 1 peut être ouverte ou fermée.

On rappelle que la porosité est dite ouverte ou interconnectée lorsque les pores ou canaux de porosité sont reliés entre eux et traversent le support. La porosité est dite fermée ou non interconnectée lorsque tous les pores ne sont pas interconnectés et que les pores qui débouchent sur une face n'atteignent pas l'autre face.

Contrairement aux supports en silicium massif, la porosité du support 1 fait qu'il peut être perméable à un gaz, à un liquide ou à un matériau visqueux, propriété qui va être exploitée par la suite.

En figure 1A, le support 1 est dopé de type P+, c'est-à-dire avec une concentration de dopants supérieure ou égale à 10¹⁸ atomes par cm³. Le dopage du support 1 peut être réalisé de diverses manières. Par exemple, des dopants peuvent être introduits après formation du support par l'intermédiaire des canaux de porosité. Aussi, des dopants peuvent avoir été mélangés aux poudres de silicium avant frittage ou les poudres frittées peuvent avoir été préalablement dopées.

Le fait que le support 1 soit poreux permet de faire entrer les dopants rapidement et à grande profondeur, ce qui présente un avantage par rapport au silicium massif. Par exemple, si on veut doper une zone de type P ou P⁺ dans du silicium massif à l'aide de bore, la pénétration du bore est lente, de l'ordre de 0,1 µm à 1000°C pendant une heure. Dans la présente invention, on peut doper par diffusion le support 1 rapidement dans tout son volume et à plus basse température.

En figure 1B, le support 1 est surmonté d'une couche 3 et d'une couche 5.

La couche 3 repose sur le support 1 et est en silicium dopé de type P, c'est-à-dire avec une concentration de dopants inférieure à 10¹⁸ atomes par cm³. La couche 3 est assez épaisse, typiquement de l'ordre de 20 µm. Bien entendu, la couche 3 peut présenter diverses épaisseurs, par exemple aller de 10 à 50 µm. La couche 3 est en silicium dense, non poreux. Par exemple, il s'agit d'une couche de silicium monocristallin rapportée par collage ou résultant d'un dépôt par épitaxie en phase gazeuse ou liquide. Dans ce dernier cas, une couche préalable a pu être déposée sur le support puis recristallisée, ou bien le support peut avoir été recristallisé en surface. Le but de la recristallisation est d'augmenter la taille des grains et les rendre par exemple millimétriques ou centimétriques.

La couche 5 repose sur la couche 3. La couche 5 est en silicium dopé de type N, avec une concentration en dopants inférieure à 10¹⁸ atomes par cm³, ou de type N+, avec une concentration en dopants supérieure ou égale à 10¹⁸ atomes par cm³. La couche 5 est obtenue par exemple en revêtant la couche 3 d'un matériau contenant du phosphore et en pratiquant un recuit. La couche 5 est très mince, typiquement de l'ordre de 0,1 micromètre. Une jonction PN se trouve à l'interface des couches 3 et 5.

En figure 1C, des tranchées 7 sont pratiquées au laser de façon à séparer des zones 9 formées d'une partie des couches 3 et 5. Les zones 9 peuvent avoir la forme d'un carré, d'un rectangle, ou toute autre forme, de préférence pavable. Les zones 9 peuvent aussi être des bandes s'étendant sur tout ou partie de la largeur du support 1. Les dimensions des zones 9 peuvent être quelconques, mais de préférence pluricentimétriques. Par exemple, les zones 9 sont des carrés de 2 à 10 centimètres de côté.

Les tranchées 7 sont assez profondes pour qu'il ne reste plus de couche 3 entre les zones 9. Les tranchées 7 peuvent s'arrêter sur le support 1 ou être plus profondes et pénétrer dans le support 1. Les tranchées 7 peuvent être peu larges, par exemple d'une largeur de 100 µm.

La figure 1D illustre une étape d'oxydation. Cette étape d'oxydation est remarquable en ce qu'elle n'a pas d'équivalent dans l'état de la technique.

En figure 1D, une couche 11 est déposée sur la face inférieure du support 1. La couche 11 empêche tout agent gazeux, liquide ou visqueux de pénétrer par la face inférieure du support 1. La couche 11 est par exemple une couche de nitrure de silicium épaisse de 0,1 µm. La couche 11 peut aussi être constituée d'une couche de nitrure de silicium reposant sur une couche de silice plus fine, par exemple de 25 nanomètres, afin de limiter les contraintes exercées par la couche de nitrure de silicium.

Après dépôt de la couche 11, on fait agir sur la structure de l'oxygène soit sous forme de vapeur d'eau H₂O soit sous forme de dioxygène O₂ ou d'un mélange de dioxygène et de vapeur d'eau. Le mélange gazeux contenant l'oxygène pénètre dans le support 1 par les canaux de porosité au niveau des tranchées 7. Le trajet de l'oxygène est symbolisé en figure 1D par des flèches portant l'indication O₂.

Des zones oxydées 14 se forment sous les tranchées 7. Le processus est contrôlé pour que les zones 14 atteignent la face inférieure du support 1 mais pour qu'elles ne se rejoignent pas. Ainsi, les zones 14 délimitent des caissons 18 dopés P+, isolés les uns des autres et qui rejoignent la face inférieure du support 1. La couche 11 est de préférence enlevée après le processus d'oxydation.

L'oxydation du support 1 est rapide car le fluide oxydant pénètre dans les canaux de porosité et oxyde rapidement le silicium pour former un matériau en général partiellement oxydé, désigné par Sᵢ0ₓ en figure 1D. L'oxydation du silicium, même partielle, rend la zone oxydée isolante.

On notera que de l'oxyde se forme en général sur la couche 5. Du fait que la couche 5 est en silicium massif, l'épaisseur d'oxyde qui s'y forme est très faible. Cette couche d'oxyde peut être retirée ultérieurement ou laissée et servir par la suite de couche de passivation et/ou de couche antireflet de la future cellule photovoltaïque.

On notera aussi que l'oxydation décrite en relation avec la figure 1D est réalisée avec un support présentant une porosité ouverte, dont les pores sont traversants. L'étape d'oxydation peut aussi être réalisée si le support présente une porosité fermée. Dans ce cas, la couche 11 n'est pas réalisée et de l'oxygène pénètre aussi par la face inférieure du support 1. Le processus est contrôlé pour que les zones oxydées à partir des tranchées 7 rejoignent ou chevauchent les zones oxydées à partir de la face inférieure du support 1. Des caissons P+ isolés les uns des autres par des zones oxydées sont aussi créés, mais ils n'atteignent pas la face inférieure du support 1.

Pour terminer les cellules photovoltaïques, il faut placer un peigne collecteur sur la couche 5 de chaque zone 9 et former le cas échéant des couches de passivation et/ou antireflet. Ces étapes sont classiques et ne seront pas décrites ici. On notera seulement que la mise en place des peignes collecteurs peut être faite sur la couche d'oxyde née lors de l'étape d'oxydation, un recuit permettant au matériau conducteur du peigne de traverser la couche d'oxyde et d'assurer le contact électrique avec la couche 5 dopée N.

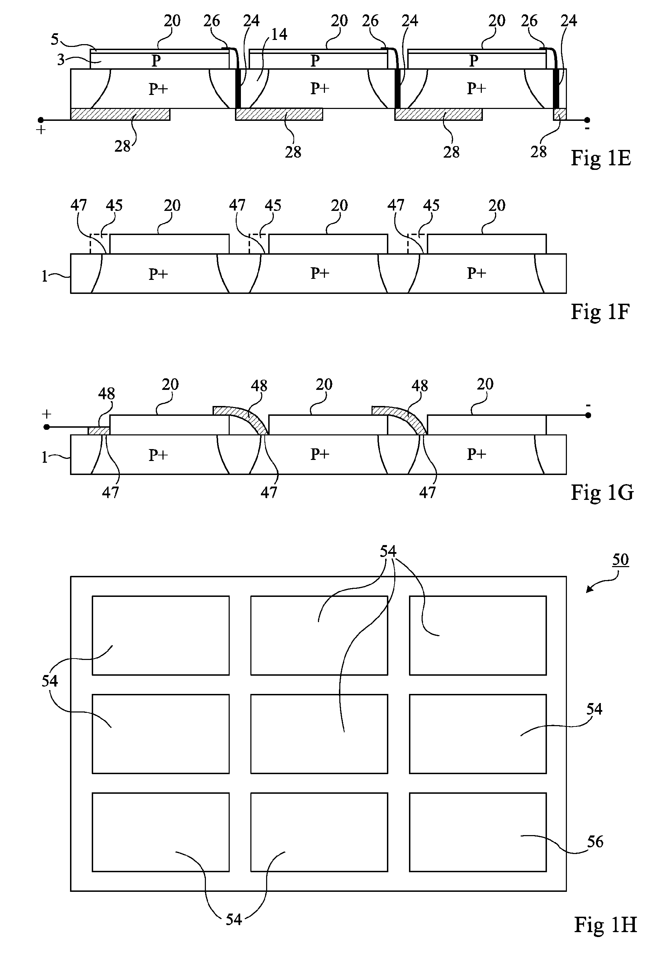

La connexion en série des cellules photovoltaïques peut être réalisée de diverses manières. Les figures 1E à 1G illustrent des exemples pour connecter les cellules.

En figure 1E, des peignes ont été réalisés sur les zones 9 de la figure 1D, les zones 9 formant désormais des cellules photovoltaïques 20.

Des vias conducteurs 24 traversent le support 1 dans les parties oxydées 14. Le peigne d'une cellule 20, non représenté, est relié au via 24 adjacent à la cellule par une liaison 26. A la face arrière du support 1, une métallisation 28 réunit le via 24 d'une cellule 20 au caisson P+ de la cellule 20 suivante.

Le caisson P+ de la première cellule est connecté à une borne externe formant la borne + du module photovoltaïque et le via 24 de la dernière cellule est connecté à une borne externe formant la borne - du module photovoltaïque. On peut bien entendu ne pas réaliser le dernier via 24 et connecter la borne - du module au peigne de la dernière cellule.

Plusieurs vias peuvent être prévus par cellule, le nombre des vias étant fonction de l'intensité maximale pouvant être fournie par les cellules.

On notera que si les caissons P+ n'atteignent pas la face inférieure du support 1, des vias conducteurs supplémentaires seront prévus pour relier au caisson P+ la métallisation 28 afin de connecter les cellules en série.

Les figures 1F et 1G représentent un autre mode de connexion en série des cellules 20.

En figure 1F, des tranchées 45 sont réalisés sur un des bords des cellules 20. Les tranchées 45 s'arrêtent à la surface du support 1 et découvrent une zone 47 du caisson dopé P+.

En figure 1G, une liaison conductrice 48, par exemple une métallisation, réunit le peigne non représenté de chaque cellule 20 à la zone 47 de la cellule suivante. Les cellules sont ainsi connectées en série. La borne + du module est reliée à la zone 47 de la première cellule et la borne - du module est reliée au peigne de la dernière cellule.

La figure 1H est une vue de dessus d'un module photovoltaïque 50 selon la présente invention.

Le module 50 a été réalisé selon un procédé décrit en relation avec les figures 1A à 1G. Le module 50 comporte ainsi de nombreuses cellules 54 intégrées sur un support en silicium fritté. Les cellules 54 sont connectées en série.

Le module 50 peut comporter une zone 56 sur laquelle n'ont pas été réalisées de cellules photovoltaïques. La zone 56 peut comporter par exemple des circuits électroniques intégrés de régulation ou de sécurité, le support 1 agissant comme substrat pour ces circuits.

La zone 56 peut comporter des composants électroniques ou un circuit comportant une ou plusieurs diodes permettant de mettre en court-circuit un groupe de cellules qui subirait un ombrage. Ces circuits n'existent pas de façon intégrée au module dans l'art antérieur, et sont généralement en périphérie du module.

Les composants spécifiques servant à protéger ou à contrôler le fonctionnement d'une ou d'un groupe de cellules peuvent être réalisés préalablement sur des éléments de plaquette semiconductrice monocristalline et rapportés sur le support 1 ou sur des couches de semiconducteur polycristallin déposées sur le support 1. Un onduleur peut aussi être intégré.

Les composants intégrés au module peuvent être par exemple des capteurs contrôlant la température des cellules ou des circuits plus complexes incluant des systèmes de régulation des tensions et courants générés par le module.

Bien entendu, avant mise sur le marché, le module 50 peut être protégé par des moyens classiques, par exemple par un film polymère et une plaque de verre sur sa face avant, destinée à être exposée au soleil (dite face supérieure dans ce qui précède), et/ou un film polymère et une plaque de verre ou une plaque de polymère ou de céramique sur sa face arrière.

Le module 50 peut délivrer une tension de sortie quelconque, chaque cellule photovoltaïque délivrant approximativement une tension de 0,6 volt. Par exemple, la tension délivrée par le module peut aller de quelques volts à plusieurs centaines de volts. L'intensité que peut délivrer le module 50 est modulable en fonction de la taille des cellules ou de leur branchement, certaines cellules pouvant être connectées en parallèle. La taille des cellules peut varier de quelques centimètres carrés à plusieurs centaines de centimètres carrés.

Le module photovoltaïque 50 peut être de grande dimension, la taille du module étant choisie en fonction de l'application souhaitée. La taille du module peut par exemple aller de 0,25 mètre carré à un mètre carré ou plus. La puissance délivrée peut être de l'ordre de 150 watts par mètre carré.

Le module 50 n'est pas nécessairement plan, les techniques de frittage permettant de réaliser des supports courbes.

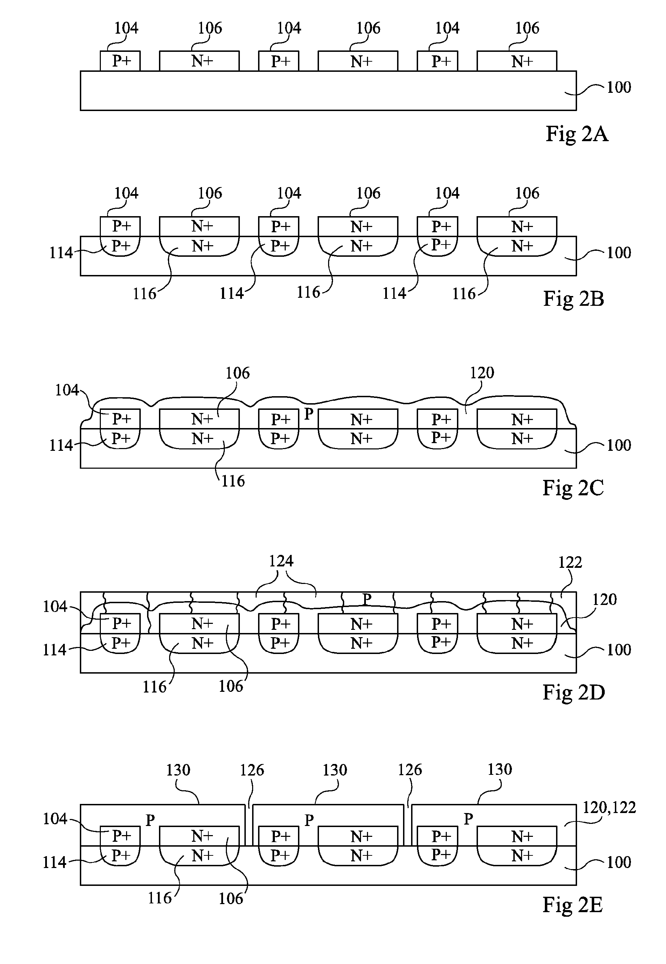

On va maintenant décrire un deuxième exemple de réalisation de module photovoltaïque en relation avec les figures 2A à 2G.

Dans ce deuxième exemple, toutes les connexions sont faites par l'arrière et les peignes sont enterrés, ce qui permet de diminuer l'ombrage créé par des connexions qui seraient déposées sur la face avant, améliorant ainsi le rendement de la cellule.

En figure 2A, un support 100 est réalisé par frittage de poudres de silicium, comme le support 1 de la figure 1A. Cependant, en figure 2A, le support 100 n'est pas dopé et il est naturellement isolant.

Sur le support 100 reposent des zones 104 dopées P+ et des zones 106 dopées N+. Les zones 104 et 106 peuvent par exemple résulter du dépôt d'un matériau contenant du bore ou du phosphore, ou résulter du dépôt de couches de silicium contenant du bore ou du phosphore. Bien que les dimensions et les formes des zones 104 et 106 puissent être quelconques, les zones 104 et les zones 106 sont de préférence interdigitées et l'espace les séparant est faible, par exemple de l'ordre de 10 à 100 µm. Les zones dopées P+ sont de préférence moins larges que les zones dopées N+. Par exemple, les zones 104 ont une largeur de 100 µm et les zones 106 ont une largeur de 500 µm.

En figure 2B, on réalise un recuit de la structure et les dopants des zones 104 et 106 migrent dans le support 100. Ainsi, en figure 2B, des zones 114 dopées P+ se trouvent sous les zones 104 et des zones 116 dopées N+ se trouvent sous les zones 106. Si cela est souhaité, une brève étape d'oxydation peut être réalisée pour s'assurer que les zones 114 et 116 sont bien isolées électriquement les unes des autres.

Les figures 2C et 2D illustrent les étapes de formation de l'absorbeur des futures cellules photovoltaïques.

En figure 2C, une couche 120 de silicium dopée P est déposée, par exemple par CVD, sur la structure de la figure 2B. La couche 120 a une épaisseur relativement faible, par exemple 2 µm. Après son dépôt, la couche 120 est recristallisée, par exemple par ZMR ("Zone Melting Recrystallization"), c'est-à-dire par balayage d'une zone fondue en surface, afin d'augmenter la taille des grains, qui deviennent centimétriques dans la direction du balayage.

En figure 2D, une couche 122 dopée P est déposée par épitaxie sur la couche 120. La couche épitaxiée 122 a une épaisseur de l'ordre de 20 µm. Bien entendu, elle peut avoir une autre épaisseur, par exemple de 10 à 50 µm. La couche 122 présente des grains 124 en continuité avec les grains de la couche 120. Les grains 124 traversent toute la couche 122, ce qui favorise le rendement de la future cellule en diminuant le piégeage des porteurs.

En figure 2E, des tranchées 126 sont pratiquées par exemple au laser pour séparer les futures cellules. Les tranchées 126 atteignent le support 100. Les tranchées 126 entourent totalement la future cellule 130. Bien qu'en figure 2E les tranchées 126 n'isolent qu'une paire de zones adjacentes 104 et 106, en pratique, les cellules étant de taille centimétrique, les tranchées 126 peuvent isoler plusieurs dizaines de paires de zones P+ et N+. Cela n'a pas été représenté en figure 2E pour des raisons de clarté.

Ensuite, on dépose sur les cellules une couche antireflet et une couche de passivation. Bien entendu, une seule couche peut servir de couche antireflet et de couche de passivation. La ou les couches antireflet et/ou de passivation ne sont pas représentées en figure 2E.

On notera que la jonction PN des cellules 130 se trouve à l'interface des zones 106 dopées N+ et de l'absorbeur formé par les couches 120 et 122. Les zones 106 servent aussi à évacuer les trous produits par les photons, et les zones 104 servent à évacuer les électrons.

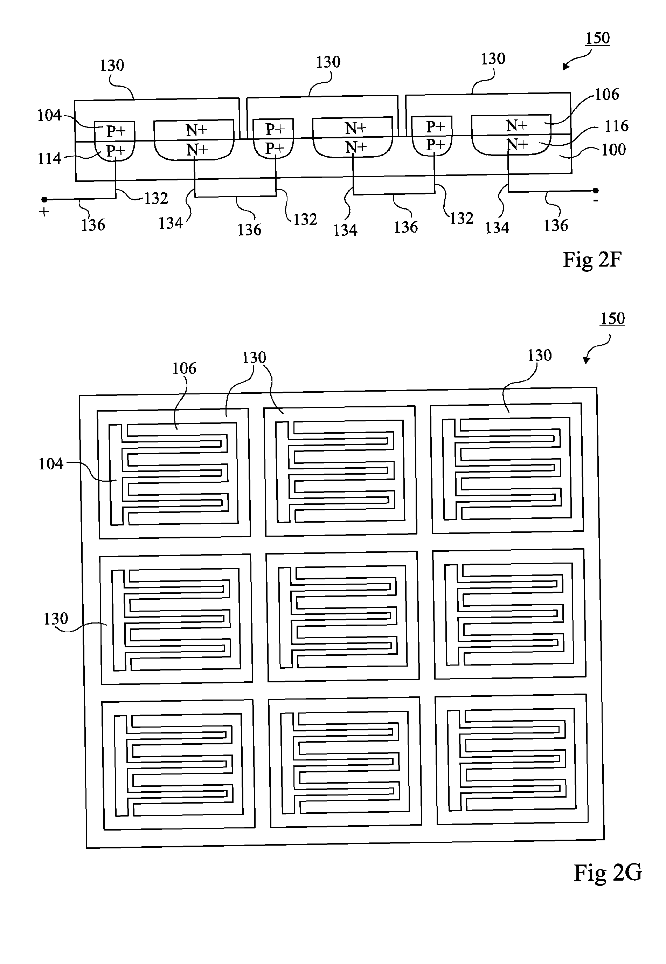

La figure 2F illustre la connexion des cellules 130 en série.

En figure 2F, des vias conducteurs 132 joignent la face arrière du support 100 et les zones 114 dopées P+. Des vias conducteurs 134 joignent la face arrière du support 100 et les zones 116 dopées N+. Plusieurs vias 132 et 134 peuvent être nécessaires par cellule pour faire passer l'intensité maximale pouvant être fournie. Une liaison conductrice 136, comme une métallisation, réunit les vias 132 d'une cellule aux vias 134 de la cellule suivante. Comme en figure 2E, les cellules 130 sont représentées avec une seule zone P+ 114 et une seule zone N+ 116, pour des raisons de clarté. Dans la pratique, toutes les zones P+ 114 d'une même cellule sont connectées ensemble et toutes les zones N+ 116 d'une même cellule sont connectées ensemble.

Les cellules sont ainsi connectées en série et forment un module photovoltaïque 150. La borne + du module 150 est reliée à la zone P+ 114 de la première cellule et la borne - du module 150 est reliée à la zone N+ 116 de la dernière cellule.

Il va de soi que des cellules peuvent être aussi connectées en parallèle. De façon générale, à intensité et tension égales, un module avec des cellules plus petites et plus nombreuses peut être préféré à un module avec de grandes cellules, pour diminuer le courant traversant chaque cellule et/ou augmenter la tension délivrée par le module.

Le fonctionnement du module, comme des cellules, est à la portée de l'homme du métier et ne sera pas décrit plus avant.

La figure 2G représente la face avant du module 150, exposée au soleil. Neuf cellules 130 sont représentées en figure 2G. Les peignes collecteurs correspondent aux zones 104 et 106 et sont enterrés. Pour des raisons de clarté, une seule paire de zones 104 et 106 a été représentée par cellule en figure 1G. Il va de soi qu'en pratique chaque cellule peut comprendre plus d'une paire de zones 104 et 106.

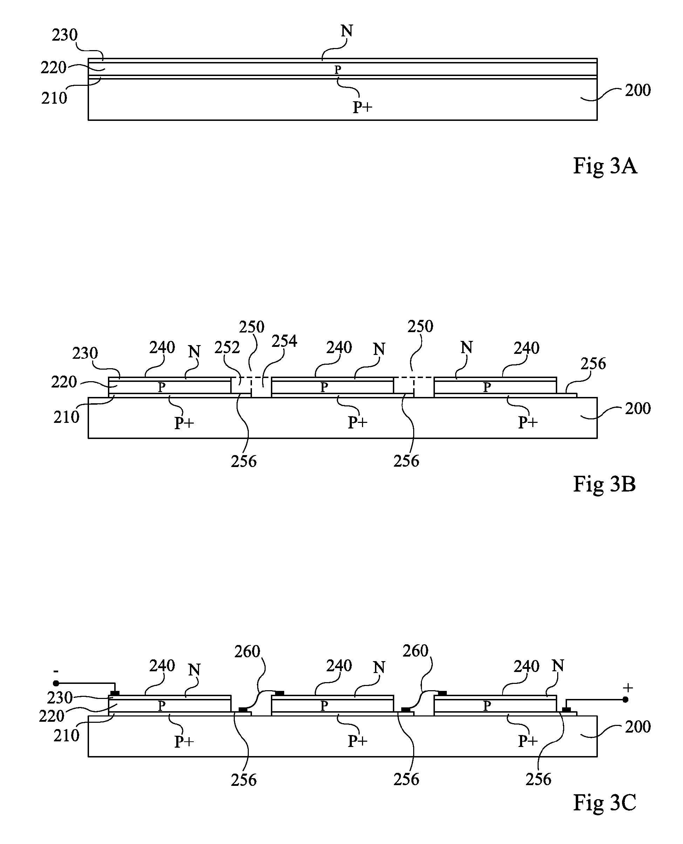

Pour montrer que la présente invention est susceptible de nombreuses variantes et modifications sans sortir du cadre de l'invention, on va maintenant décrire, en relation avec les figures 3A à 3C, un troisième exemple de module photovoltaïque selon de la présente invention, où toutes les connexions se trouvent sur la face avant.

En figure 3A, un support 200 est surmonté d'une couche 210 dopée P+. Sur la couche 210, se trouve une couche 220 dopée P. Une couche 230 dopée N se trouve sur la couche 220.

Le support 200 est en silicium fritté. Le support 200 est analogue aux supports 1 et 100 décrits précédemment. Le support 200 peut indifféremment être dopé ou non dopé.

La couche 210 peut être mince (quelques µm) et avoir été déposée et recristallisée pour présenter des grains de taille importante, typiquement millimétriques ou centimétriques. La couche 210 peut aussi être plus épaisse, par exemple de 10 à 100 µm, et avoir été réalisée en recuisant la surface supérieure du support 200 et en la dopant P+, sauf si le support a déjà été dopé P+.

La couche 220 peut avoir été déposée par épitaxie sur la couche 210 et présenter de gros grains en continuité avec les grains de la couche 210. La couche 220, destinée à former l'absorbeur des cellules, a une épaisseur typique comprise entre 10 et 50 µm.

La couche 230 est mince, typiquement de l'ordre de 1 micromètre. La couche 230 peut avoir été réalisée comme la couche 5 de la figure 1B. Une jonction PN se trouve à l'interface des couches 220 et 230.

En figure 3B, des cellules 240 sont isolées les unes des autres par des tranchées 250. Les tranchées 250 sont formées d'une partie 252 et d'une partie 254. La partie 252 s'arrête à l'interface des couches 210 et 220. La partie 254 est assez profonde pour que soit interrompue la couche 210, qu'elle provienne d'une couche déposée ou d'un dopage en surface du support 200. Ainsi, un méplat 256 découvrant une portion de la couche 210 P+ apparait au bord de chaque cellule 240.

Si le support 200 est en silicium dopé, on fait agir un agent oxydant par l'intermédiaire des tranchées 250 afin d'éviter tout contact électrique des cellules 240 via le support 200. L'étape d'oxydation ayant été décrite en relation avec la figure 1D, on ne la détaillera pas. L'étape d'oxydation n'est pas essentielle si le support en silicium fritté est non dopé et si la couche 210 a été déposée, mais elle pourra néanmoins être maintenue dans tous les cas par mesure de sécurité.

Des peignes conducteurs, non représentés, sont réalisés sur la face avant des cellules 240.

En figure 3C, des liaisons électriques 260 sont réalisées pour relier le méplat 256 d'une cellule 240 au peigne collecteur de la cellule suivante.

Le module photovoltaïque est terminé par l'adjonction de couches de passivation et/ou antireflet puis encapsulé avant mise sur le marché. On ne détaillera pas ces étapes. On n'a pas détaillé non plus les mesures à prendre pour éviter d'éventuels courts-circuits pouvant se former entre les couches 220 et 230 d'une même cellule du fait de la liaison 260, l'homme du métier étant à même de résoudre ces problèmes lorsqu'ils se posent.

On notera que l'exemple de réalisation des figures 3A à 3C s'adapte particulièrement bien à la réalisation de cellules sous forme de bandes s'étendant sur toute la largeur du module. En effet, la séparation des cellules est alors réalisée de façon particulièrement simple, car il s'agit de pratiquer de simples rayures s'étendant d'un bord à l'autre du support. Les bandes peuvent être peu larges, par exemple larges de 1 centimètre, notamment si le module doit fournir une tension élevée.

En conclusion, on notera que l'utilisation d'un support en silicium fritté pour réaliser des modules photovoltaïques selon la présente invention présente de nombreux avantages.

Par exemple, les supports en silicium fritté sont bon marché, notamment parce qu'ils peuvent être réalisés à partir de poudres de silicium peu pures, le cas échéant en silicium métallurgique.

Les supports en silicium fritté peuvent être de dimensions bien plus grandes que les plaquettes actuelles en silicium mono-, multi- ou polycristallin. Les supports en silicium fritté ne sont pas nécessairement plans.

Aussi, les étapes technologiques pour réaliser des cellules sur un support en silicium fritté sont souvent assez simples. Par exemple, dans la présente invention, l'isolement électrique des caissons portant les cellules est réalisé techniquement par pénétration d'un agent oxydant dans les canaux de porosité du support.

Des exemples de réalisation particuliers de la présente invention ont été décrits. Il va de soi que ces exemples ne sont pas limitatifs. Diverses variantes et modifications apparaîtront à l'homme du métier, qui pourra combiner divers éléments de ces divers modes de réalisation et variantes sans faire preuve d'activité inventive.

Par exemple, les dopages des diverses couches et zones décrites dans les exemples ci-dessus ne sont pas limitatifs. Ainsi, il est équivalent d'inverser tous les dopages indiqués.

Aussi, les étapes des procédés ne sont données qu'à titre d'exemple. L'homme du métier pourra modifier ces étapes, le cas échéant en intervertir l'ordre, sans sortir du cadre de la présente invention.

De façon générale, la présente invention concerne les modules photovoltaïques comprenant un support en silicium fritté et des cellules photovoltaïques. Il est entendu que, quelles que soient la forme, la structure et/ou les étapes utilisées pour réaliser le module et/ou les cellules photovoltaïques du module, tout module photovoltaïque comportant un support en silicium fritté fait partie du domaine de la présente invention.

## Revendications

1. Module photovoltaïque (50, 150) comprenant un support en silicium fritté (1, 100, 200) comportant plusieurs cellules photovoltaïques (20, 130, 240) intégrées.

2. Module photovoltaïque selon la revendication 1, dans lequel les cellules photovoltaïques sont isolées les unes des autres par des parties (14) oxydées du support en silicium fritté.

3. Module photovoltaïque selon la revendication 2, dans lequel les parties oxydées s'étendent d'une face à l'autre du support.

4. Module photovoltaïque selon l'une quelconque des revendications 1 à 3, dans lequel les cellules photovoltaïques sont connectées en série.

5. Module photovoltaïque selon l'une quelconque des revendications 1 à 4, dans lequel chacune des cellules photovoltaïques comprend une première zone (18, 104, 114, 210) fortement dopée d'un premier type dans et/ou sur le support et une deuxième zone (3, 120, 122, 220) disposée au moins en partie sur la première zone, d'un dopage de même type que la première zone et moins dopée que la première zone, la première zone définissant une première borne de la cellule photovoltaïque.

6. Module photovoltaïque selon la revendication 5, dans lequel chacune des cellules photovoltaïques (20, 240) comprend une troisième zone (5, 230) dopée d'un deuxième type différent du premier type et disposée sur la deuxième zone, la troisième zone définissant une deuxième borne de la cellule.

7. Module photovoltaïque selon la revendication 5, dans lequel chacune des cellules photovoltaïques (130) comprend une quatrième zone (106, 116) fortement dopée d'un deuxième type différent du premier type et disposée sous la deuxième zone, la quatrième zone définissant une deuxième borne de la cellule.

8. Module photovoltaïque selon la revendication 6 ou la revendication 7, comprenant des vias (24, 132, 134) permettant la connexion des cellules par la face arrière du support destinée à ne pas être exposée au soleil.

9. Module photovoltaïque selon l'une quelconque des revendications précédentes, dans lequel les cellules photovoltaïques ont la forme de bandes s'étendant d'un bord à l'autre du module.

10. Procédé de fabrication d'un module photovoltaïque comprenant un support comportant plusieurs cellules photovoltaïques intégrées, **caractérisé en ce que** le support est réalisé au cours d'une étape consistant à fritter des poudres de silicium.

11. Procédé selon la revendication 10, comportant une étape consistant à introduire localement un agent oxydant dans le support de façon à le rendre localement isolant afin de réaliser, dans le support, des zones isolées électriquement les unes des autres.

12. Procédé selon la revendication 11, dans lequel les cellules photovoltaïques sont réalisées sur lesdites zones isolées électriquement les unes des autres.

13. Procédé selon la revendication 10 ou la revendication 12, dans lequel la réalisation des cellules photovoltaïques (20, 240) comprend les étapes suivante :
a) réaliser une première zone (18, 210), fortement dopée d'un premier type, dans ou sur le support, la première zone définissant une première borne de la cellule photovoltaïque ;
b) réaliser sur la première zone une deuxième zone (3, 220) d'un dopage de même type que la première zone et moins dopée que la première zone ; et
c) réaliser sur la deuxième zone une troisième zone (5, 230) dopée d'un deuxième type différent du premier type, la troisième zone définissant une deuxième borne de la cellule photovoltaïque.

14. Procédé selon la revendication 10 ou la revendication 12, dans lequel la réalisation des cellules photovoltaïques (130) comprend les étapes suivante :
a) réaliser une première zone (104, 114) fortement dopée d'un premier type dans et sur le support, la première zone définissant une première borne de la cellule photovoltaïque ;
b) réaliser, dans et sur le support, une deuxième zone (106, 116) fortement dopée d'un deuxième type différent du premier type, adjacente et sans contact avec la première zone, la deuxième zone définissant une deuxième borne de la cellule photovoltaïque ; et
c) réaliser sur les première et deuxième zones une troisième zone (120, 122) d'un dopage de même type que la première zone et moins dopée que la première zone.

15. Procédé selon l'une quelconque des revendications 10 à 14, comprenant une étape consistant à connecter au moins deux cellules photovoltaïques en série.
